# EUROPEAN PATENT APPLICATION

(11) **EP 2 453 437 A2**
(43) Date of publication of application: **16.05.2012**
(21) Application number: 12154030.6
(22) Date of filing: 18.04.2007
(51) Int. Cl.: G10L 19/00, G10L 19/14, G10L 19/04

(54) **Method and apparatus for lossless encoding of a source signal, using a lossy encoded data stream and a lossless extension data stream**

(30) Priority: 05.05.2006 EP 06113596
(62) Divisional of application: 07728246.5
(71) Applicant: Thomson Licensing, 92130 Issy-les-Moulineaux (FR)
(72) Inventor: Jax, Peter, 30171 Hannover (DE); Keiler, Florian, 30161 Hannover (DE); Wuebbolt, Oliver, 30161 Hannover (DE); Kordon, Sven, 31515 Wunstorf (DE); Boehm, Johannes, 37081 Göttingen (DE)
(74) Representative: Hartnack, Wolfgang

(57) **Abstract**

In lossy based lossless coding a PCM audio signal passes through a lossy encoder (101) to a lossy decoder (102). The lossy encoder provides a lossy bit stream (111). The lossy decoder also provides side information (115) that is used to control (105) the coefficients (118) of a prediction filter (106) that de-correlates the difference signal (104) between the PCM signal and the lossy decoder output. The de-correlated difference signal is lossless encoded (108), providing an extension bit stream (121). The lossy encoded bit stream together with the lossless encoded extension bit stream form a lossless encoded bitstream. The invention facilitates enhancing a lossy perceptual audio encoding/decoding by an extension that enables mathematically exact reproduction of the original waveform, and provides additional data for reconstructing at decoder site an intermediate-quality audio signal. The lossless extension can be used to extend the widely used mp3 encoding/decoding to lossless encoding/decoding and superior quality mp3 encoding/decoding.

## Description

The invention relates to a method and to an apparatus for lossless encoding of a source signal, using a lossy encoded data stream and a lossless extension data stream which together form a lossless encoded data stream for said source signal.

### Background

In contrast to lossy audio coding techniques (like mp3, AAC etc.), lossless compression algorithms can only exploit redundancies of the original audio signal to reduce the data rate. It is not possible to rely on irrelevancies, as identified by psycho-acoustical models in state-of-the-art lossy audio codecs. Accordingly, the common technical principle of all lossless audio coding schemes is to apply a filter or transform for de-correlation (e.g. a prediction filter or a frequency transform), and then to encode the transformed signal in a lossless manner. The encoded bit stream comprises the parameters of the transform or filter, and the lossless representation of the transformed signal.
See, for example, J. Makhoul, "Linear prediction: A tutorial review", Proceedings of the IEEE, Vol.63, pp.561-580, 1975, T. Painter, A. Spanias, "Perceptual coding of digital audio", Proceedings of the IEEE, Vol.88, No.4, pp.451-513, 2000, and M. Hans, R.W. Schafer, "Lossless compression of digital audio", IEEE Signal Processing Magazine, July 2001, pp.21-32.

The basic principle of lossy based lossless coding is depicted in Fig. 3 and Fig. 4. In the encoding part on the left side of Fig.38, a PCM audio input signal S_{PCM} passes through a lossy encoder 81 to a lossy decoder 82 and as a lossy bit stream to a lossy decoder 85 of the decoding part (right side). Lossy encoding and decoding is used to de-correlate the signal. The output signal of decoder 82 is removed from the input signal S_{PCM} in a subtractor 83, and the resulting difference signal passes through a lossless encoder 84 as an extension bit stream to a lossless decoder 87. The output signals of decoders 85 and 87 are combined 86 so as to regain the original signal S_{PCM}.

This basic principle is disclosed for audio coding in EP-B-0756386 and US-B-6498811, and is also discussed in P. Craven, M. Gerzon, "Lossless Coding for Audio Discs", J. Audio Eng. Soc., Vol.44, No.9, September 1996, and in J. Koller, Th. Sporer, K.H. Brandenburg, "Robust Coding of High Quality Audio Signals", AES 103rd Convention, Preprint 4621, August 1997.

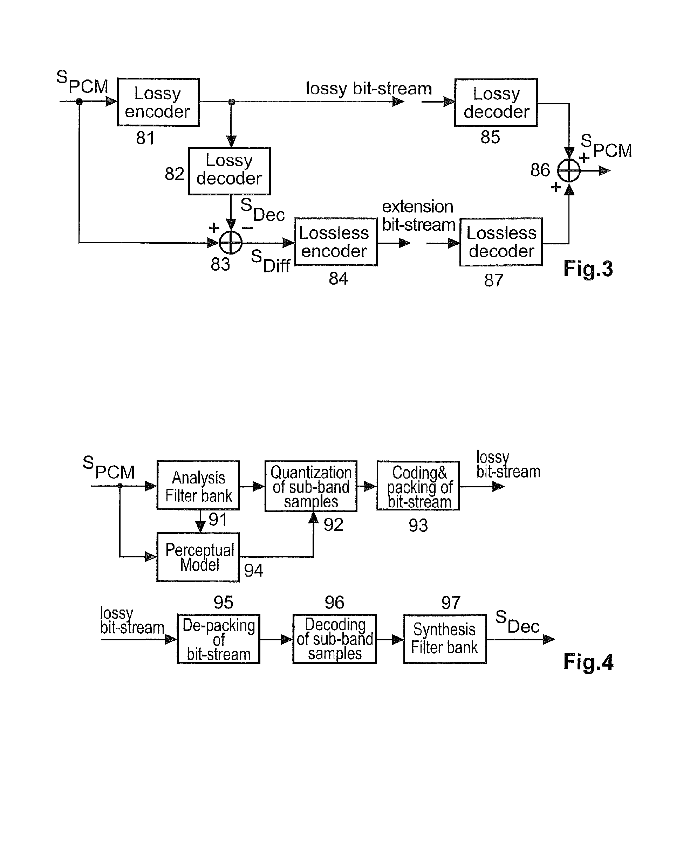

In the lossy encoder in Fig. 4, the PCM audio input signal S_{PCM} passes through an analysis filter bank 91 and a quantisation 92 of sub-band samples to a coding and bit stream packing 93. The quantisation is controlled by a perceptual model calculator 94 that receives signal S_{PCM} and corresponding information from the analysis filter bank 91. At decoder side, the encoded lossy bit stream enters a means 95 for de-packing the bit stream, followed by means 96 for decoding the subband samples and by a synthesis filter bank 97 that outputs the decoded lossy PCM signal S_{Dec}. Examples for lossy encoding and decoding are described in detail in the standard ISO/IEC 11172-3 (MPEG-1 Audio).

In the state of the art, lossless audio coding is pursued based on one of the following three basic signal processing concepts:
a) time domain de-correlation using linear prediction techniques;
b) frequency domain lossless coding using reversible integer analysis-synthesis filter banks;
c) lossless coding of the residual (error signal) of a lossy base layer codec.

### Invention

A problem to be solved by the invention is to provide hierarchical lossless audio encoding and decoding, which is build on top of an embedded lossy audio codec and which provides a better efficiency (i.e. compression ratio) as compared to state-of-the-art lossy based lossless audio coding schemes. This problem is solved by the methods disclosed in claims 1 and 3. Apparatuses that utilise these methods are disclosed in claims 2 and 4, respectively.

This invention uses a mathematically lossless encoding and decoding on top of a lossy coding. Mathematically lossless audio compression means audio coding with bit-exact reproduction of the original PCM samples at decoder output. For some embodiments it is assumed that the lossy encoding operates in a transform domain, using e.g. frequency transforms like MDCT or similar filter banks. As an example, the mp3 standard (ISO/IEC 11172-3 Layer 3) will be used for the lossy base layer throughout this description, but the invention can be applied together with other lossy coding schemes (e.g. AAC, MPEG-4 Audio) in a similar manner. The transmitted or recorded encoded bit stream comprises two parts: the embedded bit stream of the lossy audio codec, and extension data for one or several additional layers to obtain either the lossless (i.e. bit-exact) original PCM samples or intermediate qualities.

The invention basically follows version c) of the above-listed concepts. However, the inventive embodiments utilise features from concepts a) and b) as well, i.e. a synergistic combination of techniques from several ones of the state-of-the-art lossless audio coding schemes.

The invention uses frequency domain de-correlation, time domain de-correlation, or a combination thereof to prepare the residual signal (error signal) of the base-layer lossy audio codec for efficient lossless encoding. The proposed de-correlation techniques make use of side information that is extracted from the lossy decoder. Thereby, transmission of redundant information in the bit stream is prevented, and the overall compression ratio is improved.

Besides the improved compression ratio, some embodiments of the invention provide the audio signal in one or several intermediate qualities (in the range limited by the lossy codec and mathematically lossless quality). Furthermore, the invention allows for stripping of the embedded lossy bit stream using a simple bit dropping technique.

Three basic embodiments of the invention differ in the domain, in which the de-correlation of the residual signal of the lossy base layer codec takes place: in time domain, in frequency domain, or in both domains in a coordinated manner. In contrast to the prior art, all embodiments utilise information taken from the decoder of the lossy base-layer codec to control the de-correlation and lossless coding process. Some of the embodiments additionally use information from the encoder of the lossy base-layer codec. The exploitation of side information from the lossy base-layer codec allows for reduction of redundancies in the gross bit stream, thus improving the coding efficiency of the lossy based lossless codec.

In all embodiments at least two different variants of the audio signal with different quality levels can be extracted from the bit stream. These variants include the signal represented by the embedded lossy coding scheme and the lossless decoding of the original PCM samples. In some embodiments (see section *Frequency domain de-correlation)* it is possible to decode one or several further variants of the audio signal with intermediate qualities.

In principle, the inventive encoding method is suited for lossless encoding of a source signal, using a lossy encoded data stream and a lossless extension data stream which together form a lossless encoded data stream for said source signal, said method including the steps:
- lossy encoding said source signal, wherein said lossy encoding provides said lossy encoded data stream;
- lossy decoding said lossy encoded data, thereby reconstructing a decoded signal and providing side information for controlling a time domain prediction filter;
- forming a difference signal between a correspondingly delayed version of said source signal and said decoded signal,
- prediction filtering said difference signal using filter coefficients that are derived from said side information so as to de-correlate in the time domain the consecutive values of said difference signal;
- lossless encoding said de-correlated difference signal to provide said lossless extension data stream;
- combining said lossless extension data stream with said lossy encoded data stream to form said lossless encoded data stream.

In principle, the inventive decoding method is suited for decoding a lossless encoded source signal data stream, which data stream was derived from a lossy encoded data stream and a lossless extension data stream which together form a lossless encoded data stream for said source signal, wherein:
said source signal was lossy encoded, said lossy encoding providing said lossy encoded data stream;
said lossy encoded data were correspondingly lossy decoded, thereby reconstructing a standard decoded signal and side
information was provided for controlling a time domain prediction filter;
a difference signal between a correspondingly delayed version of said source signal and said decoded signal was formed;
said difference signal was prediction filtered using filter coefficients that were derived from said side information so as to de-correlate in the time domain the consecutive values of said difference signal;
said de-correlated difference signal was lossless encoded to provide said lossless extension data stream;
said lossless extension data stream was combined with said lossy encoded data stream to form said lossless encoded data stream,
said method including the steps:
   - de-multiplexing said lossless encoded source signal data stream to provide said lossless extension data stream and said lossy encoded data stream;
   - lossy decoding said lossy encoded data stream, thereby reconstructing a lossy decoded signal and providing said side information for controlling a time domain prediction filter;
   - decoding said lossless extension data stream so as to provide said de-correlated difference signal;
   - inversely de-correlation filtering consecutive values of said de-correlated difference signal using filter coefficients that are derived from said side information;
   - combining said de-correlation filtered difference signal with said lossy decoded signal to reconstruct said source signal.

The inventive apparatuses carry out the functions of the corresponding inventive methods.

Advantageous additional embodiments of the invention are disclosed in the respective dependent claims.

### Drawings

Exemplary embodiments of the invention are described with reference to the accompanying drawings, which show in:

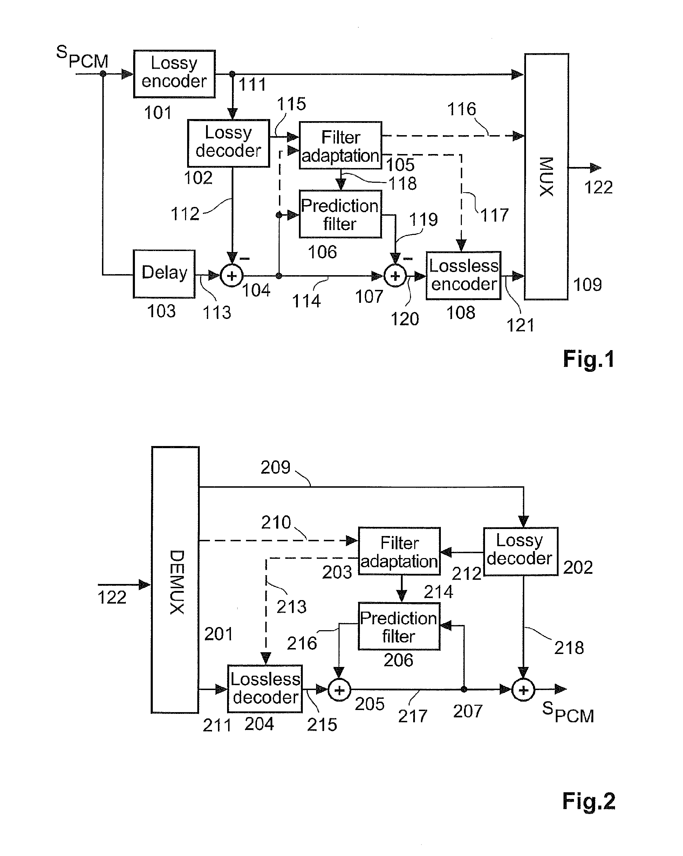

- Fig. 1: block diagram or signal flow of lossy based lossless encoder with decor relation of the residual signal using time domain linear prediction;
- Fig. 2: block diagram or signal flow of lossy based lossless decoder with decor relation of the residual signal using time domain linear prediction;
- Fig. 3: basic block diagram for a known lossy based lossless encoder and decoder;
- Fig. 4: general block diagram for a known lossy encoder and decoder.

### Exemplary embodiments

### Time domain de-correlation

This embodiment makes use of the known residual coding principle.

In the encoding depicted in Fig. 1, the encoding starts with a lossy encoder step or stage 101, yielding the lossy bit stream 111 which is passed to a MUX block 109. A corresponding lossy decoder 102 produces the decoded audio signal 112 and some side information 115 to be used for control of a time domain linear prediction filter. This side information 115 comprises for example a set of parameters that describe the spectral envelope of the error (i.e. the residual signal 114) of the lossy codec 101/102, i.e. of the difference formed in a subtractor 104 between the (lossy) decoded audio signal 112 and the properly delayed original PCM samples 113. Delay 103 compensates for any algorithmic delay that is caused by the chain of lossy encoder 101 and lossy decoder 102. The side information can also include one or more of the following: block sizes, window functions, cut-off frequencies, bit allocations.

The side information 115 that is extracted from the lossy decoder 102 (and possibly signal 114, in particular in case the lossy encoder 101 encodes a partial audio signal frequency range only, or for facilitating a more exact determination of the filter coefficients in step/stage 105) is used in a filter adaptation block 105 to determine a set 118 of optimum filter coefficients to be applied in a linear prediction filter 106. The aim of the prediction filtering and the subtraction 107 is to produce a de-correlated output signal 120 with a flat (i.e. 'white') spectrum. A white signal is perfectly de-correlated, and the corresponding consecutive time domain samples or values exhibit the lowest possible power and entropy. Thus, a better de-correlation of the signal leads to lossless coding with lower average data rate. Compared to known lossy based lossless approaches, the invention allows for a very good de-correlation, but without the need to transmit a large amount of information on the prediction filter settings. The corresponding information stream 116 is always lower in data rate than for systems without exploitation of side information 115 from the lossy decoder. Ultimately, the extra information 116 to be transmitted for the adaptation of the prediction filter coefficients at decoding side may be zero. That is, the coding efficiency of the proposed approach is always better than that of similar lossy based lossless audio coding methods.

In general, any useful information (parameters, signals etc.) from the lossy decoder can be exploited to improve both the adaptation of the prediction filter and the lossless encoder.

To be operational, the lossy decoder 102, the time domain linear prediction filter 106, the delay compensation 103, the subtraction points 104 and 107, and any interpolation functionalities, that may optionally be implemented inside the lossy decoder block 102, are to be implemented in a platform-independent manner. That is, for all targeted platforms a fixed-point implementation with integer precision is required that produces bit-exactly reproducible results.

The prediction error signal 120 is fed to a lossless encoding block 108 which produces an encoded bit stream 121. Advantageously, since the prediction error signal 120 can be assumed to be de-correlated (white), a simple memoryless entropy coding (e.g. Rice coding) may be used in lossless encoder 108. The lossless encoding may be supported optionally by additional side information 117 to be derived during filter adaptation of filter adaptation block 105. For example, the estimated power of the residual signal 120 may be provided as side information 117, which is a by-product of state-of-the-art prediction filter adaptation methods. Multiplexer 109 combines the partial bit streams 111, 116 and 121 to form output bit stream signal 122, and may produce different file formats or bit stream formats for output bit stream 122.

The term 'lossy decoder' means the exact decoding of the lossy encoded bit stream, i.e. the inverse operation of the lossy encoder.

In the decoding in Fig. 2, the incoming gross bit stream 122 is split into sub bit streams by a demultiplexer 201. A lossy decoder 202, implemented to produce exactly the same outputs as decoder 102 in a platform-independent manner, produces the lossy decoded time signal 218 and side information 212. From this side information and any optional bit stream components 210 (corresponding to signal 116 in Fig. 1), the filter adaptation can be performed in filter adaptation block 203 exactly like in the corresponding encoding block 105. Demultiplexer 201 also provides a lossy extension bit stream 211 to a lossless decoder 204, the output signal 215 of which is fed to an inverse de-correlation filter comprising an adder 205 and a prediction filter 206 that is controlled by the filter coefficients 214 provided by block 212, thus producing a bit-exact replica 217 of the lossy codec error signal 114. Addition 207 of this error signal to the decoded signal 218 from lossy decoder 202 yields the original PCM samples S_{PCM}. Fiter coefficients 214 are identical to filter coefficients 118. The operations of elements 202, 204, 205, 206 and 207 are identical to that of the respective elements 102, 108, 107, 106 and 104.

### Optional embodiments

This basic processing can be applied in different manners.

Instead of the feed-forward linear prediction filter structure comprising blocks 106 and 107 in Fig. 1, other variants of time domain linear prediction filters may be used. For example, backward prediction or a combination of backward prediction and the above-described forward prediction. Another option is to use a long-term prediction filter in addition to any of these short-term prediction techniques.

Additional side information 117/213, extracted from the filter adaptation block 105/203, can be used to control the lossless encoding/decoding block 108/204. For example, the standard deviation of the prediction residual, as estimated by common filter adaptation techniques, can be used to parameterise the lossless coding, e.g. for selecting Huffman tables. This option is illustrated by the dashed lines for signals 117/213 in figures 1 and 2.

The proposed embodiments can be applied on top of all kinds of codecs for which it is possible to determine or estimate the power spectrum of the error signal from the set of parameters available at the decoder. Thus, this hierarchical codec processing can be applied to a wide range of audio and speech codecs.

### An example implementation

Assuming that the lossy base-layer codec is compliant to the mp3 standard, it is possible to determine optimum coefficients for a time domain linear prediction filter from the set of scale factors. In the mp3 codec, the scale factors describe the quantisation step size to be applied for encoding the MDCT coefficients. That is, it is possible to derive the envelope of the power spectrum of the error signal from the set of scale factors for each signal frame (granule).

Let Sₑₑ(i) denote the scale factor for the i-th MDCT coefficient, represented in the power spectrum domain. Then, the auto-correlation coefficients ϕ*ₑₑ*(*k*) = IDFT{*Sₑₑ*(*i*)} can be determined by inverse discrete Fourier transform (IDFT). Application of the Levinson-Durbin algorithm (Makhoul, cited above) will produce the desired set *aᵢ, i*=1...*p* of optimum filter coefficients 118/214 to be applied in the p-th order linear prediction filter 106/206. This procedure is repeated for each frame (granule) of the audio signal. In addition to the set of filter coefficients *aᵢ, i*=1...*p,* the Levinson-Durbin algorithm produces the expected variance of the prediction error signal 120/215. This variance is important information to control the subsequent lossless encoding 108 of the prediction residuum.

If the mp3 encoder excludes certain frequency ranges from bit allocation (e.g. high frequencies at low data rates), or uses advanced coding tools, more sophisticated schemes are applied. Further, in certain frequency ranges the estimate *sₑₑ*(*i*) of the power spectrum of the error signal may not have the desired precision to be used for filter adaptation. Then, additional information is to be obtained by examination of the error signal 114. This may be performed both in time domain and in frequency domain.

### Frequency domain de-correlation

In this embodiment the de-correlation of the residual is performed in the transform domain of the lossy codec. However, the actual lossless coding is still performed in the time domain. Therefore, this method is different from known lossy based lossless schemes and transform based lossless coding approaches. The proposed embodiment combines the advantages of transform domain de-correlation and time domain based lossless coding approaches.

## Claims

1. Method for lossless encoding of a source signal (S_{PCM}), using a lossy encoded data stream (111) and a lossless extension data stream (121) which together form a lossless encoded data stream (122) for said source signal, said method including the steps:
- lossy encoding (101) said source signal, wherein said lossy encoding provides said lossy encoded data stream (111),
**characterised by**:
- lossy decoding (102) said lossy encoded data, thereby reconstructing a decoded signal (112) and providing side information (115) for controlling a time domain prediction filter;
- forming (104) a difference signal (114) between a correspondingly delayed (103) version of said source signal and said decoded signal (112),
- prediction filtering (106, 107) said difference signal using filter coefficients (118) that are derived (105) from said side information so as to de-correlate in the time domain the consecutive values of said difference signal;
- lossless encoding (108) said de-correlated difference signal (120) to provide said lossless extension data stream (121);
- combining (109) said lossless extension data stream with said lossy encoded data stream to form said lossless encoded data stream (122).

2. Apparatus for lossless encoding of a source signal (S_{PCM}), using a lossy encoded data stream (111) and a lossless extension data stream (121) which together form a lossless encoded data stream (122) for said source signal, said apparatus including:
- means (101) being adapted for lossy encoding said source signal, wherein said lossy encoding provides said lossy encoded data stream (111),
**characterised by**:
- means (102) being adapted for lossy decoding said lossy encoded data, thereby reconstructing a decoded signal (112) and providing side information (115) for controlling a time domain prediction filter;
- means (104, 103) being adapted for forming a difference signal (114) between a correspondingly delayed version of said source signal and said decoded signal (112),
- means (105, 106, 107) being adapted for prediction filtering said difference signal using filter coefficients (118) that are derived from said side information so as to de-correlate in the time domain the consecutive values of said difference signal;
- means (108) being adapted for lossless encoding said de-correlated difference signal (120) to provide said lossless extension data stream (121);
- means (109) being adapted for combining said lossless extension data stream with said lossy encoded data stream to form said lossless encoded data stream (122).

3. Method for decoding a lossless encoded source signal (S_{PCM}) data stream, which data stream was derived from a lossy encoded data stream (111) and a lossless extension data stream (121) which together form a lossless encoded data stream (122) for said source signal, wherein:
said source signal was lossy encoded (101), said lossy encoding providing said lossy encoded data stream (111);
said lossy encoded data were correspondingly lossy decoded (102), thereby reconstructing a standard decoded signal (S_{Dec}) and side information (115) was provided for controlling a time domain prediction filter;
a difference signal (114) between a correspondingly delayed (103) version of said source signal and said decoded signal (112) was formed (104);
- said difference signal was prediction filtered (106, 107) using filter coefficients (118) that were derived (105) from said side information so as to de-correlate in the time domain the consecutive values of said difference signal;
- said de-correlated difference signal (120) was lossless encoded (108) to provide said lossless extension data stream (121);
- said lossless extension data stream was combined (109) with said lossy encoded data stream to form said lossless encoded data stream (122),
said method including the steps:
- de-multiplexing (201) said lossless encoded source signal data stream (122) to provide said lossless extension data stream (211) and said lossy encoded data stream (209);
- lossy decoding (202) said lossy encoded data stream, thereby reconstructing a lossy decoded signal (218) and providing said side information (212) for controlling a time domain prediction filter;
- decoding (204) said lossless extension data stream so as to provide said de-correlated difference signal (215);
- inversely de-correlation filtering (205, 206) consecutive values of said de-correlated difference signal using filter coefficients (214) that are derived (203) from said side information (212);
- combining (207) said de-correlation filtered difference signal (217) with said lossy decoded signal (218) to reconstruct said source signal (S_{PCM}).

4. Apparatus for decoding a lossless encoded source signal (S_{PCM}) data stream, which data stream was derived from a lossy encoded data stream (111) and a lossless extension data stream (121) which together form a lossless encoded data stream (122) for said source signal, wherein:
said source signal was lossy encoded (101), said lossy encoding providing said lossy encoded data stream (111);
said lossy encoded data were correspondingly lossy decoded (102), thereby reconstructing a standard decoded signal (S_{Dec}) and side information (115) was provided for controlling a time domain prediction filter;
a difference signal (114) between a correspondingly delayed (103) version of said source signal and said decoded signal (112) was formed (104);
- said difference signal was prediction filtered (106, 107) using filter coefficients (118) that were derived (105) from said side information so as to de-correlate in the time domain the consecutive values of said difference signal;
- said de-correlated difference signal (120) was lossless encoded (108) to provide said lossless extension data stream (121);
- said lossless extension data stream was combined (109) with said lossy encoded data stream to form said lossless encoded data stream (122),
said apparatus including:
- means (201) being adapted for de-multiplexing said lossless encoded source signal data stream (122) to provide said lossless extension data stream (211) and said lossy encoded data stream (209);
- means (202) being adapted for lossy decoding said lossy encoded data stream, thereby reconstructing a lossy decoded signal (218) and providing said side information (212) for controlling a time domain prediction filter;
- means (204) being adapted for decoding said lossless extension data stream so as to provide said de-correlated difference signal (215);
- means (205, 206) being adapted for inversely de-correlation filtering consecutive values of said de-correlated difference signal using filter coefficients (214) that are derived (203) from said side information (212);
- means (207) being adapted for combining said de-correlation filtered difference signal (217) with said lossy decoded signal (218) to reconstruct said source signal (S_{PCM}).

5. Method according to claim 1, or apparatus according to claim 4, wherein from said side information (115) prediction filter settings data (116) are derived and included in said lossless encoded data stream (122), or side information prediction filter settings data (210) are taken from said lossless encoded data stream (122) and are used for generating (203) said prediction filtering coefficients (214).

6. Method according to the method of claims 1 or 5, or apparatus according to the apparatus of claims 2 or 5, wherein the standard deviation (117, 213) of the prediction residual is used to parameterise said lossless encoding (108), or to control said lossless decoding (204), respectively.

7. Storage medium, for example on optical disc, that contains or stores, or has recorded on it, a digital signal encoded according to the method of one of claims 1, 5 and 6.
